# EUROPEAN PATENT APPLICATION

(11) **EP 2 090 994 A2**
(43) Date of publication of application: **19.08.2009**
(21) Application number: 09152847.1
(22) Date of filing: 13.02.2009
(51) Int. Cl.: G06F 17/50, G06T 17/10

(54) **System, method and computer program product for computer modeling with generative components**

(30) Priority: 13.02.2008 US 30408
(71) Applicant: Bentley Systems, Incorporated, Exton, PA 19341-0678 (US)
(72) Inventor: Brown, Jeffrey, West Chester, PA 19380 (US); Aish, Robert, Winchester, Hampshire SO22 5HD (GB)
(74) Representative: Herbjörnsen, Rut

(57) **Abstract**

A computer-implemented method in a computer modeling environment having generative components may include defining an update method of a parent generative component (GC) feature including means for creating a collection containing at least one child generative component feature; creating a parent generative component feature having the defined update method; executing the update method for the parent generative component feature including creating the collection of child generative component features; and returning the collection as the value of the update method, wherein the contents of the collection are automatically associated with the parent generative component feature.

## Description

### Background

### Related Art

In computer aided design (CAD) environments, a model or design, e.g. an engineering or architectural design, may be created from geometric 'elements' (e.g. lines, arcs, circles, curves, surfaces, solids, text, etc.) that may be recorded (and made persistent) in a design file (e.g. a .dgn file, .dwg file, etc.). The CAD environment may also provide a set of interactive commands to place and edit these elements. The result of using these commands is 'persisted', but the commands themselves are 'transient'. Knowledge of how an element has been created or edited is generally not recorded in the design file.

Generative components (GC) may provide an alternative structure and technique for designing CAD elements, and using the GC elements in models or designs. GC may provide a set of features, for example, lines, curves, arcs, user-defined feature types etc., where each feature may have one or more "update" methods that may define how an feature of a feature type is initialized and updated when the design is modified. Each GC feature may have an associated set of 'update' methods corresponding to different ways to define the feature.

GC features may be dependent on other GC features or existing elements. For example, a GC circle feature may have an update function that creates a circle from a center point and a radius length. The center point of the circle may itself be a GC point, for example, the point at the intersection of two lines. If the point that defines the center of the circle moves, then the GC circle may update the circle accordingly, in this case, by moving the circle to the center's new position.

A GC-based modeling environment may "remember" how each GC feature is created and/or updated, rather than "remembering" only a final result. Remembering the creation or update method of a GC feature may allow the GC system to re-generate or revise the feature appropriately as changes are propagated through the model.

### Summary

In an exemplary embodiment, the invention may be a computer-implemented method in a computer modeling environment having generative components, the method comprising:
defining an update method of a parent generative component (GC) feature including means for creating a collection containing at least one child GC feature; creating a parent GC feature having the defined update method; executing the update method for the parent GC feature including creating the collection of child GC features; and returning the collection as the value of the update method, wherein the contents of the collection are automatically associated with the parent GC feature.

Defining the update method may further include defining the update method with a return value and at least one argument. Creating the collection of child GC features may include setting a value for at least one of a setting or a property for a child GC feature, and the at least one argument may include at least one of: a value indicating a number of child GC features to create in the collection; or the value for the child GC feature setting or property.

The method may further include: performing an action on the parent GC feature, wherein the action is automatically performed on the child GC features in the collection of the parent GC feature.

Executing the update method may include executing the update method as part of a GC script.

The method may further include: updating a GC graph to include the collection; and displaying one of a symbolic representation or a geometric representation of the GC graph.

The method may further include: storing the update method and the collection on a computer-readable medium.

The method may further include: downloading software to a computer system, which when executed by the computer system causes the computer system to perform operations comprising the method of claim 1; or providing downloadable software to a computer system, which when executed by the computer system causes the computer system to perform operations comprising the method of claim 1.

In another exemplary embodiment, the invention may be a generative component (GC) system in a computer modeling environment comprising: a parent GC feature comprising:
at least one user-defined update method having a return value; and a collection of a plurality of child GC features created when the at least one user-defined update method is executed; a GC graph comprising: at least two GC features, including at least one parent GC feature, and at least one relationship between the at least two GC features; and at least one of a memory to store, or a display to display, the GC features in the GC graph.

The GC graph may include at least one of: a symbolic representation to display the GC features in the GC graph and the relationships among the GC features in the graph; or a geometric representation to display information about a GC feature in the GC graph. The symbolic representation may represent the collection of GC child features as one graph element; and the geometric representation may represent the collection of GC child features as one graph element for each GC child feature.

The system may further include at least one of: a script editor to edit GC scripts; a transaction recorder to record transaction on GC features; a script execution engine to execute GC scripts; or a model including GC features.

In another exemplary embodiment, the invention may be a computer program comprising: one or more computer-executable instructions which, when run on a computer system, causes the computer system to define an update method for a parent generative component (GC) feature; one or more computer-executable instructions which, when run on a computer system, causes the computer system to create at least one child GC feature within the update method; one or more computer-executable instructions which, when run on a computer system, causes the computer system to execute the update method including creating at least one child GC feature and creating a collection containing the at least one child GC feature; and one or more computer-executable instructions which, when run on a computer system, causes the computer system to return the collection as the value of the update method, wherein the contents of the collection are automatically associated with the parent GC feature.

The one or more instructions for defining the update method for the parent may include one or more instructions for defining a sub-function within the update method. The one or more instructions for defining a sub-function may further include one or more instructions for receiving an argument indicating a number of times to recursively call the sub-function.

In yet another exemplary embodiment, the invention may be a computer-readable medium comprising a computer program as defined above.

### Brief Description of the Drawings

In the accompanying drawings:

FIG. 1 depicts an exemplary embodiment of a technical modeling environment (TME) that may be configured to implement generative components and CAD models;

FIG. 2 depicts an exemplary embodiment of a generative component feature;

FIG. 3 depicts an exemplary embodiment of an update method for a GC feature;

FIG. 4 depicts an exemplary embodiment of a symbolic representation of a generative component graph;

FIG. 5 depicts an exemplary embodiment of a transaction recorder;

FIG. 6 depicts an exemplary embodiment of a model;

FIG. 7 depicts a flowchart of a method according to an exemplary embodiment; and

FIG. 8 depicts an exemplary block diagram of a computer that may be configured to execute the TME illustrated in FIG. 1.

### Detailed Description of Embodiments of the Present Invention

Example embodiments of the invention are discussed below. While specific example embodiments are discussed, it should be understood that this is done for illustration purposes only.

Generative components (GC) may allow for replication of a design element. In replication, a collection of elements may be treated as a single element of the same type. For example, a collection of lines may be treated as a single line. A collection may be, for example, a list, an array, a set, etc., where a single collection element may be accessed or indexed.

Embodiments of the invention may provide, within a generative component based modeling environment, a generative component (GC) feature that may automatically create a collection of child features associated with the GC feature. The GC feature and its child features may be automatically associated with each other in a generative component graph that represents a model. The association may support replication, where actions performed on the GC feature are automatically performed on the child features without needing additionally programming, scripting, or coding from the user.

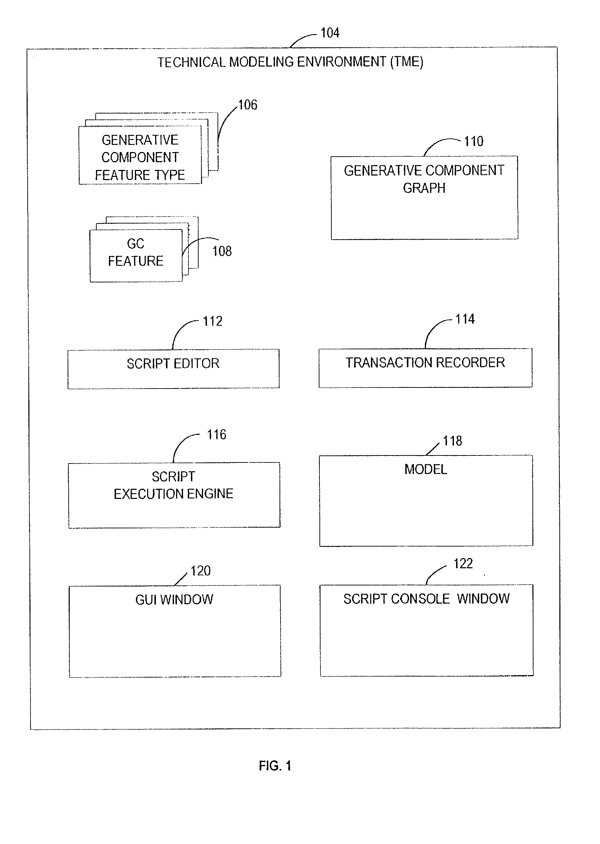

**FIG. 1** depicts an example of a technical modeling environment (TME) 104 that may be configured to provide a computer assisted design (CAD) or computer modeling software application that supports the use of GC scripting and modeling. TME 104 may provide one or more generative component feature types 106, one or more GC features 108 108, a GC graph 110, a script editor 112, a transaction recorder 114, a script execution engine 116 and a model 118. TME 104 may further provide a graphical user interface (GUI) window 120 and/or a script console window 122 to allow the user to create and use generative components to build, for example, engineering, architectural, and product designs or models.

A GC feature type 106 may be analogous to a class definition in an object-oriented programming environment. A GC feature type 106 may be used to create instances, e.g. features 108, that are analogous to CAD design elements, e.g. point, line, arc, b-spline curve, circle, user-defined feature type, ellipse, elliptical arc, shape, composite curve, B-spline surface, solid, mesh, text, text styles, etc. A GC feature type 106 may be defined in code or script that allows GC features 108 to be created as elements of a CAD model, e.g. in model 118. A GC feature type 106 may include a variety of functions. For example, a GC feature type may include functions to create a CAD element, to relate the CAD element to other CAD elements and/or to a CAD model, and/or to allow the CAD element to be updated.

A GC feature 108 may be a specific instance of a GC feature type 106. A GC feature 108 may depend on other GC features 108 when created or updated, or may itself be depended on by other GC features 108. A GC feature 108 may contain one or more properties that describe the GC feature 108. For example, a GC feature 108 may have properties that specify a specific location, direction, size, relationship to another GC feature, or other features to describe the GC feature 108. A GC feature 108 may be stored, for example, as a design element in a model, or may reside in memory on a computer.

A GC graph 110 may be one or more data structures that hold information about the GC features 108 of a model 118. GC graph 110 may manage associations among the GC features 108 in the GC graph 110. For example, a GC line feature may depend on two GC point features as end points. GC graph 110 may hold information that associates the line feature with the point features, so that if the point features change, the line feature may be updated accordingly. In an embodiment, GC graph 110 may contain the GC features 108 of a model 118.

Script editor 112 may present an interface for writing and editing a GC script. A GC script may be written in a programming language that, when executed, causes GC features 108 to be created or updated. A GC script may create CAD design elements in a CAD model from GC feature types. Script editor 112 may be graphically based and displayed, for example, in GUI window 120, or text based and displayed, for example, in script console window 122.

Transaction recorder 114 may record each action performed on the GC features 108 of a GC graph 110. For example, a change made to a GC feature 108 may be recorded as a transaction. Changes may include, for example, creating a feature 108, moving a feature 108, initializing a feature 108, deleting a feature 108, replicating a feature 108, etc. Transaction recorder 114 may record each change to GC features 108 in a GC graph 110 in the order in which the changes occurred. The recorded actions may be "played back" to re-create the GC graph and GC features 108. Recorded transactions may be re-ordered, deleted, or grouped together as needed to create the desired final result of playing back the recorded transactions. Similarly, recorded transactions may be "rewound" to remove changes from the GC graph and GC features 108 to return to an early state.

Script execution engine 116 may execute GC scripts. Script execution engine 116 may compile and execute, or interpret, GC script to create, for example, a CAD model from the GC graph 100, GC feature types 106, GC features 108, etc.

Model 118 may include one or more GC features 108 and/or CAD elements, which may be elements of a more complex design. Model 118 may be a geometric representation of the features and associations within a GC graph 110. A model 118 may represent all or part of, for example, an engineering design, an architectural design, a product design, a graphical design, etc.

GUI window 120 may be used for creating, viewing, and using GC feature types 106, GC features 108, GC graph 110, script editor 112, transaction recorder 114, and model 118 symbolically, or through menu and dialog-box driven interfaces. For example, GUI window 120 may display GC graph 110 in a symbolic representation and allow the symbols to be manipulated via dragging. GUI window 120 may provide a way to specify script expressions that interrelate the GC graph features, without requiring full knowledge of the scripting language supported by TME 104

Script console window 122 may be used for creating and using GC feature types 106, GC graph 110, script editor 112, transaction recorder 114, and model 118 in a text-based manner. For example, script console window 122 may be used for defining GC feature types 106 in a text-based scripting or programming language.

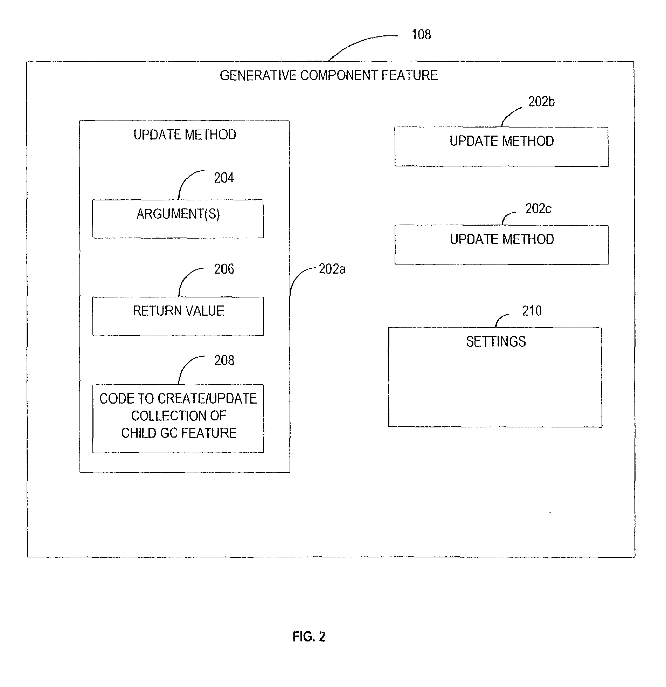

**FIG. 2** depicts a block diagram of an example of a GC feature 108. A GC feature 108 may be created by instantiation of a GC feature type 106, analogous to the way a class object may be created from a class definition in an object-oriented environment. A GC feature 108 may have at least one, and possibly several, update methods 202a, 202b, 202c, etc. For example, a GC line feature may have an update method that initializes or updates a GC line feature that is based on two points. The GC line feature may also have an update method that initializes and/or updates a line feature from the intersection of two other GC features, such as two two-dimensional (2D) or three-dimensional (3D) elements. A GC feature 108 may also have one or more settings 210. An update method 202 may be defined or provided, for example, by the user, by the provider of TME 104, by a third party provider of GC feature types 106, etc.

An update method 202 may contain programming or scripting that may initialize and/or update a GC feature 108. An update method 202 may initialize the GC feature 108 the first time the update method 202 is called, that is, the update method may establish the initial state of the GC feature 108. When called subsequently, the update method 202 may update the state of the GC feature 108, for example, when an input value changes.

An update method, e.g. update method 202a, may receive one or more arguments 204 that may be used in initializing or updating a GC feature 108 created from the GC feature type 106. Arguments may include, for example, numeric values, GC features 108, collections of GC features, arrays, lists, etc. For example, the arguments to a GC line feature update method may include the two points used to create a line feature.

Update method 202a may include a return value 206. Return value 206 may return, for example, an initialized or updated GC feature 108 to which the update method belongs, or a value indicating whether the GC feature 108 was successfully updated.

Update method 202a may include code or script 208 that, when executed, may create a collection of child GC features. The collection may be returned in return value 206 as a single collection.

When the update method 202a is executed, the GC graph 110 containing a parent feature 108 may be updated to include the collection of child GC features, and the parent and the child features may be associated with one another in the GC graph 110. The parent feature 108 may act as a placeholder for the collection. When a GC script acts upon the parent feature 108, the child features may also be automatically acted upon in the same way. For example, the parent feature 108 may be passed as an argument to a function, or to a script. When the function or script is executed on or with the parent feature, the function or script will automatically operate on the child features associated with the parent feature.

Settings 210 may include values for feature elements that may be common to more than one feature type. Generally, the value of a setting may be independent of which update method was used to create a GC feature 108. Settings 210 may be variables associated with each feature type. Examples of settings may include color, line weight, symbol location, etc.

A GC feature 108 may also include additional properties (not shown). Such properties may govern other aspects and characteristics of the GC feature 108 in addition to settings 210. Properties may be related to the active update method of the GC feature 108.

For example, suppose a GC line feature is defined to connect two points, using, e.g. the line feature's 'ByPoints' update method, passing the two points as arguments. As a result, that line feature may include the properties 'StartPoint', 'EndPoint', and 'Length'. Subsequently, the values of those properties may be referenced and used by other GC features 108 in the graph (e.g., 'myCircle.Radius = myLine.Length'). Unlike settings, the values of these kinds of properties may not be set directly by the user, but rather may be set, internally, as a byproduct of the GC feature's update method.

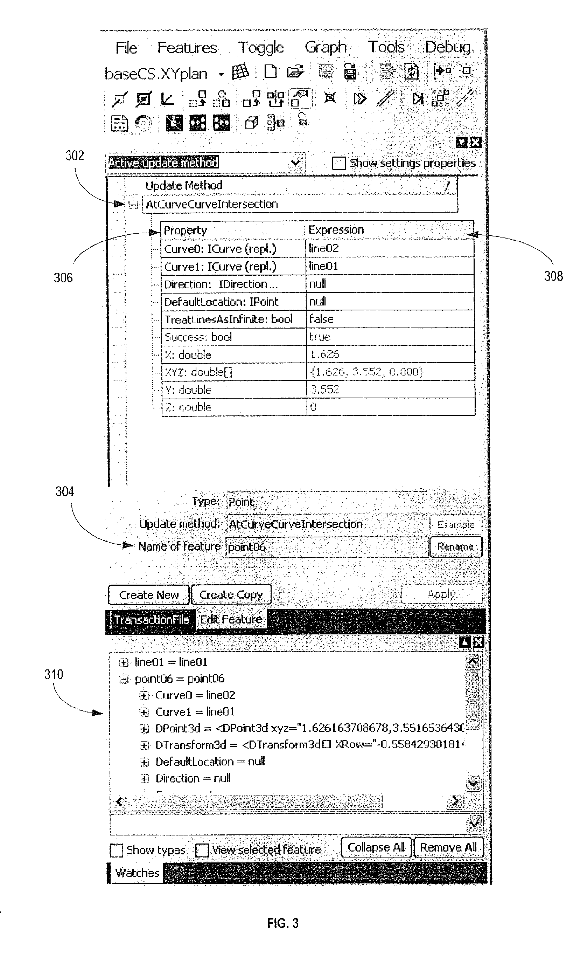

**FIG. 3** depicts example of an update method 302 for a GC point feature. The illustrated update method 302 defines a point feature 304, here named "point06," as the intersection of two curve features 108 named "Curve0" and "Curve1". The update method 302 may be displayed and edited, for example in GUI window 120. The update method 302 may be edited, for example, by modifying properties 306 of the feature. Properties may be modified by editing an expression value 308 that may define or describe a property. AN expression value 308 may be written in script language. The expression value 308 may be re-evaluated as needed, for example, when the update method 302 is called. GUI window 120 may also provide, for example, a "watches" pane 310 to allow a user to view the complete description or contents of a feature 108 in textual form.

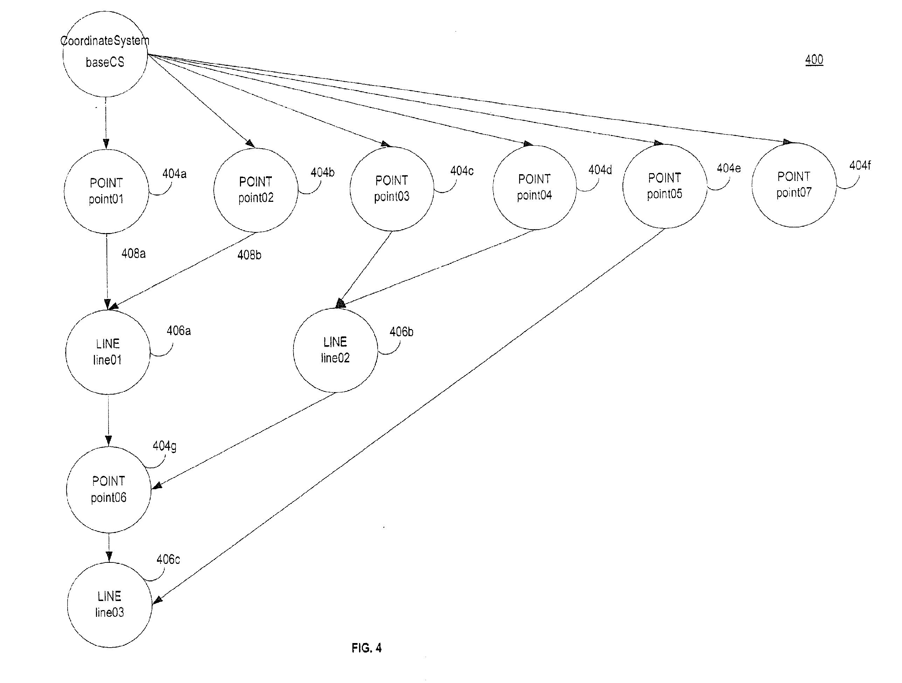

**FIG. 4** depicts an exemplary embodiment of a symbolic representation of a GC graph 400. GC graph 400 may display the features 108 of a model 118 as nodes in a graph, and may illustrate relationships among the elements with, e.g., directed lines. For example, GC graph 400 may have a root node 402 that is a coordinate system. GC graph 400 may further contain point features, e.g. points 404a, 404b, 404c, 404d, 404e, 404f, and 404g, and line features, e.g. lines 406a, 406b, and 406c.

GC graph 400 may illustrate the relationships among GC features 108. For example, line 406a may be related to points 404a and 404b, as indicated by arrows 408a and 408b, respectively. The relationship may be, for example, that points 404a and 404b are the end points of line 406a. Point 404g may be related to lines 406a and 406b, for example, as the intersection point of the lines 406a and 406b.

GC graph 400 may display how changes to a GC feature 108 may be propagated to other GC features 108 in the graph. For example, if point 404c is changed, e.g. moved, then that change may affect line 406b, which may in turn affect point 404g and line 406c.

GC graph 400 may include collections of GC features 108, which in a symbolic representation may appear in GC graph 400 as a single symbol. For example, point 404d could represent a collection, i.e. two or more, of point features. Line 406b, which may depend on point 404d, could then also be a collection of line features. For example, line 406b may be a collection of line features where each line feature in the collection has a start point at point 404c and an end point at one of the points in collection 404d.

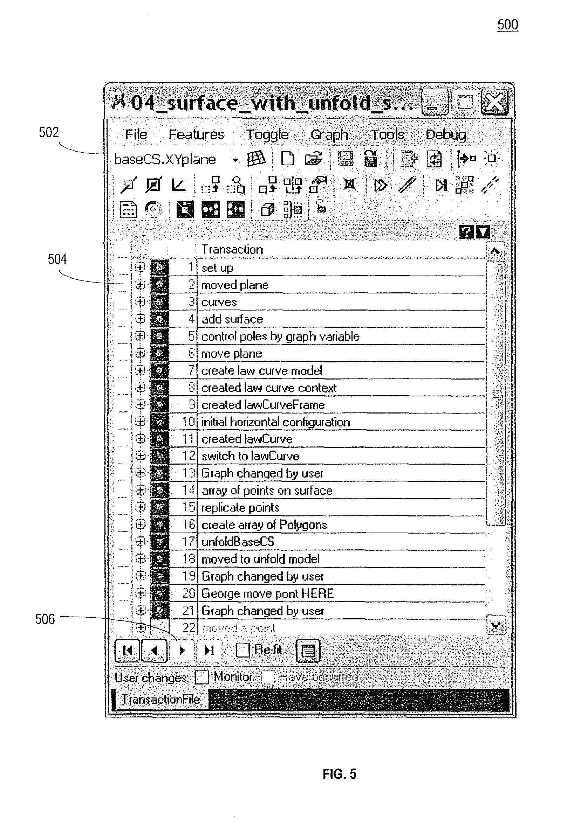

**FIG. 5****.** depicts an exemplary embodiment of a transaction recorder 500. Transaction recorder 500 may record all changes and actions performed on a feature 108, in this example, an XY plane 502. Each transaction, e.g. transaction 504, may be recorded and displayed sequentially. Transactions may be stored and "played", e.g. with play button 506, to reconstruct the sequence of transactions that lead to a particular state of a feature 108. Transactions may be deleted, re-ordered, or grouped together to achieve a particular result.

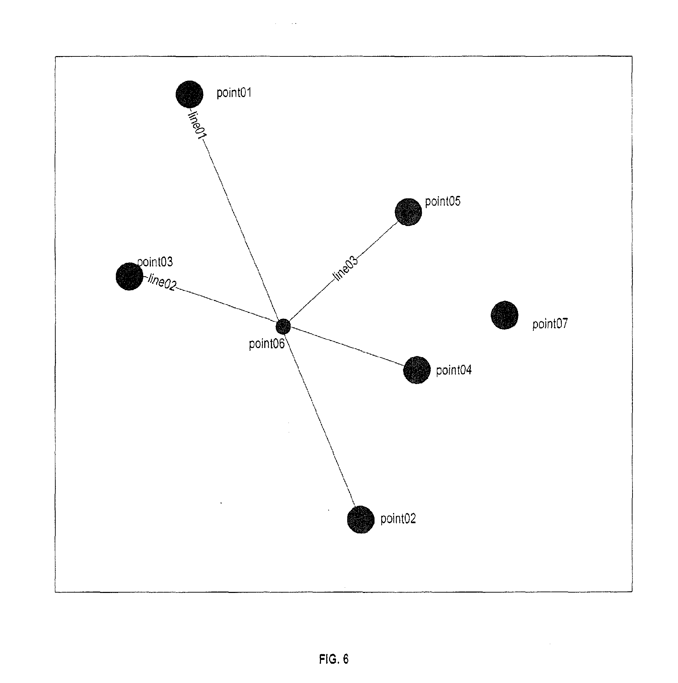

**FIG. 6** depicts an exemplary embodiment of a GC model 600. GC model 600 may be based on the GC graph 400 illustrated in FIG. 4. In an exemplary embodiment, GC model 600 may be manipulated graphically and the changes to features 108 in GC model 600 may be recorded in transaction recorder 114 and in GC graph 110. For example, a user may select a feature 108 displayed in the model and move or drag the feature to another position. The changes to the moved element may be recorded in the transaction recorder for that feature, as well as for the features that may depend on the moved feature. The data about the feature in the GC graph may also be updated, e.g. the new position, and propagated to the related features. Changes to GC graph 400 may also be propagated to model 600.

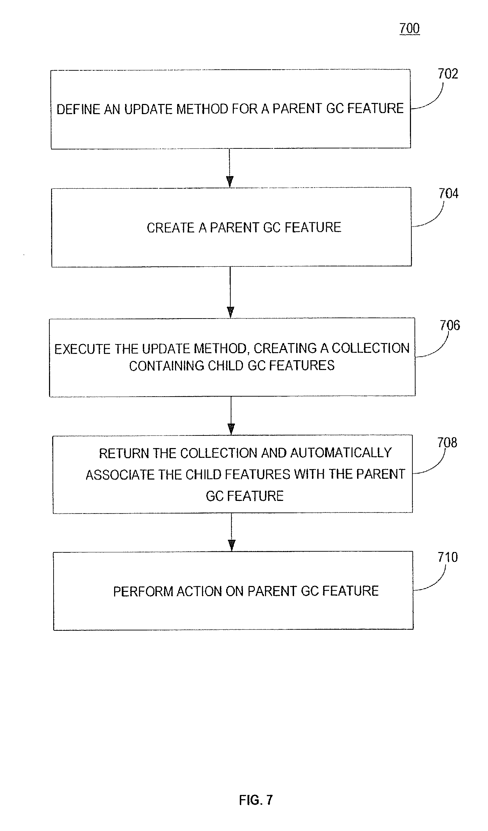

**FIG. 7** depicts a flow chart illustrating a technique of using a GC feature 108 having an update method 202 that may produce a collection of child GC features 108. In block 702, an update method 202 for a parent GC feature 108 may be defined, for example, by a user. The update method 202 may include, for example, code or script that may create a collection of one or more child GC features 108 when the update method 202 is executed.

The following pseudocode illustrates an example of an update method 202 defined in block 702:
1 update method (input arguments)
2 {
3 initialize the collection
4 for each child feature to be created
5 {
6 create the next child feature (using information provided by the input arguments)
7 add that child feature to the collection
8 }
9 return the collection
10 }
Line 1 may provide a name to the update method and list any input arguments 204 to the update method. Line 3 may include code to initialize the collection that will hold any GC child features. Lines 4 to 8 may include code to create a new child GC feature with each pass through a control loop and to add the new child GC feature to the collection. Line 9 may include code to return the collection as the value of the update method.

In block 704, a parent GC feature 108 may be created from the parent GC feature defined in block 702.

In block 706, when the update method 202 of the parent GC feature 108 is executed, the update method 202 may create a collection of the child GC features 108 defined in the update method 202, for example, using code 208. The collection may be, for example, a data structure that may contain multiple GC features 108 of the same type. The collection may be, for example, a list, an array, a vector, a spreadsheet, a database, etc.

In an exemplary embodiment, block 706 may be performed more than once after the parent GC feature is created. For example, the update method 202 may be executed when the GC graph 110 containing the parent GC feature 108 is updated or otherwise modified.

In block 708, the collection may be returned, for example as the return value 206 of the update method 202. The child GC features 108 in the collection may automatically be associated, in the GC graph 110, with the parent GC feature 108 that created the child GC features 108. Associating the child GC features with the parent GC feature 108 may include updating other GC features 108 in the graph that are related to the parent GC feature 108.

In block 710, an action may be performed on the parent GC feature 108. Performing the action on the parent GC feature 108 may automatically perform the action on the child GC features in the collection associated with the parent GC feature 108. In an exemplary embodiment, the parent GC feature may not exist as a single feature separate from the collection. Instead, the parent GC feature may be the collection of child GC features. For example, there may be no actual parent line feature, just a collection of child line features. The parent GC feature may be passed as a single value or variable, while code that acts on the parent may automatically handle individual features in the collection, enabling replication. The code may, for example, automatically create a control loop to act on each collection feature.

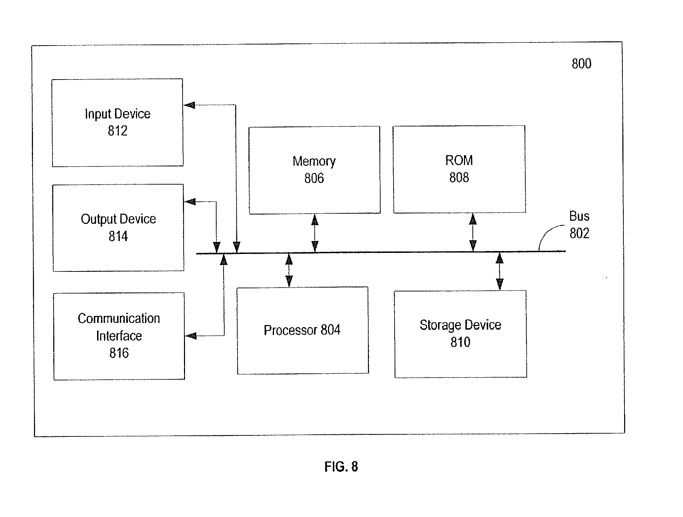

**FIG. 8** depicts an exemplary block diagram of a computer system 800 that may be configured to execute the TME illustrated in FIG. 1. Computer system 800 may include one or more components that may include a bus 802, a processor 804, a memory 806, a read only memory (ROM) 808, a storage device 810, an input device 812, an output device 814, and a communication interface 816.

Bus 802 may include one or more interconnects that permit communication among the components of computer system 800, such as processor 804, memory 806, ROM 808, storage device 810, input device 812, output device 814, and communication interface 816.

Processor 804 may include any type of processor, microprocessor, or processing logic that may interpret and execute instructions (e.g., a field programmable gate array (FPGA)). Processor 804 may comprise a single device (e.g., a single core) and/or a group of devices (e.g., multi-core). The processor 804 may include logic configured to execute computer-executable instructions configured to implement one or more embodiments. The instructions may reside in the memory 806 or ROM 808, and may include instructions associated with the TME 104.

Memory 806 may be a computer-readable medium that may be configured to store instructions configured to implement one or more embodiments. The memory 806 may be a primary storage accessible to the processor 804 and may comprise a random-access memory (RAM) that may include RAM devices, such as Dynamic RAM (DRAM) devices, flash memory devices, Static RAM (SRAM) devices, etc.

ROM 808 may include a non-volatile storage that may store information and computer-executable instructions for processor 804. The computer-executable instructions may include instructions executed by processor 804.

Storage device 810 may be configured to store information and instructions for processor 804. Examples of storage device 810 may include a magnetic disk, optical disk, flash drive, etc. The information and computer-executable instructions and information may be stored on a medium contained in the storage device 810. Examples of media may include a magnetic disk, optical disk, flash memory, etc. Storage device 810 may include a single storage device or multiple storage devices. Moreover, storage device 810 may attach directly to computer system 800 and/or may be remote with respect to computer system 800 and connected thereto via a network and/or another type of connection, such as a dedicated link or channel.

Input device 812 may include any mechanism or combination of mechanisms that may permit information to be input into computer system 800 from, e.g., a user. Input device 812 may include logic configured to receive information for computer system 800 from, e.g. a user. Examples of input device 812 may include a keyboard, mouse, touch sensitive display device, microphone, pen-based pointing device, and/or biometric input device, etc.

Output device 814 may include any mechanism or combination of mechanisms that may output information from computer system 800. Output device 814 may include logic configured to output information from computer system 800. Embodiments of output device 814 may include displays, printers, speakers, cathode ray tubes (CRTs), plasma displays, light-emitting diode (LED) displays, liquid crystal displays (LCDs), printers, vacuum florescent displays (VFDs), surface-conduction electron-emitter displays (SEDs), field emission displays (FEDs), etc.

Communication interface 816 may include logic configured to interface computer system 800 with a network and enable computer system 800 to exchange information with other entities connected to the network, such as, for example, a service provider, a target environment and a cluster. Communication interface 816 may include any transceiver-like mechanism that enables computer system 800 to communicate with other devices and/or systems, such as a client, a server, a license manager, a vendor, etc. The communications may occur over a communication medium, such as a data network. Communication interface 816 may include one or more interfaces that are connected to the communication medium. The communication medium may be wired or wireless. Communication interface 816 may be implemented as a built-in network adapter, network interface card (NIC), Personal Computer Memory Card International Association (PCMCIA) network card, card bus network adapter, wireless network adapter, Universal Serial Bus (USB) network adapter, modem or any other device suitable for interfacing computer system 800 to any type of network.

In an embodiment of the invention there is provided a generative component data structure. The generative component data structure may include: a parent GC feature comprising: means 202a for performing at least one user-defined update method; the at least one user-defined update method having a return value; and a collection of a plurality of child GC features created when the at least one user-defined update method is performed or executed. The generative component data structure may also include a GC graph comprising: at least two GC features, including at least one parent GC feature, and at least one relationship between the at least two GC features. According to an embodiment a generative component system may include the generative component data structure. An embodiment of the invention includes the generative component data structure and it may also include a memory for storing the GC features in the GC graph. Alternatively, according to another embodiment, the generative component system may include a display for displaying the GC features in the GC graph. According to yet another embodiment the generative component system may include a memory to store the GC features in the GC graph and a display to display the GC features in the GC graph.

According to an embodiment of the invention a computer modeling environment comprises a generative component (GC) system. The generative component system may include: a parent GC feature comprising: means for performing at least one user-defined update method; the at least one user-defined update method having a return value; and a collection of a plurality of child GC features created when the at least one user-defined update method is performed or executed. The generative component system may also include a GC graph comprising: at least two GC features, including at least one parent GC feature, and at least one relationship between the at least two GC features. The generative component system may also include a memory for storing the GC features in the GC graph.

Alternatively, the generative component system may include a display for displaying the GC features in the GC graph. According to an embodiment the generative component system may include a memory to store the GC features in the GC graph and a display to display the GC features in the GC graph.

The GC graph may include at least one of: a symbolic representation to display the GC features in the GC graph and the relationships among the GC features in the graph; or a geometric representation to display information about a GC feature in the GC graph. The symbolic representation may represent the collection of GC child features as one graph element; and the geometric representation may represent the collection of GC child features as one graph element for each GC child feature.

The system may further include at least one of: a script editor to edit GC scripts; a transaction recorder to record transaction on GC features; a script execution engine to execute GC scripts; or a model including GC features.

According to an embodiment the computer system 800 comprises a generative component system according to one or more of the above described embodiments.

It should be noted that embodiments may be implemented using some combination of hardware and/or software. It should be further noted that a computer-readable medium that comprises computer-executable instructions for execution in a processor may be configured to store various embodiments.

In an exemplary embodiment, the invention may be a computer-readable medium comprising computer-executable instructions, the medium comprising: one or more instructions for defining an update method for a parent generative component (GC) feature; one or more instructions for creating at least one child GC feature within the update method; one or more instructions for executing the update method including creating at least one child GC feature and creating a collection containing the at least one child GC feature; and one or more instructions for returning the collection as the value of the update method, wherein the contents of the collection are automatically associated with the parent GC feature.

The one or more instructions for defining the update method for the parent may include one or more instructions for defining a sub-function within the update method. The one or more instructions for defining a sub-function may further include one or more instructions for receiving an argument indicating a number of times to recursively call the sub-function.

The computer-readable medium may include volatile memories, non-volatile memories, flash memories, removable discs, non-removable discs and so on. In addition, it should be noted that various electromagnetic signals may be encoded to carry computer-executable instructions and/or computer data that embodies the invention. Such electromagnetic signals may be wireless signals, electrical signals carried over a wire, or optical signals carried over optical fiber and the like. Hence, an electromagnetic signal, encoded to carry computer-executable instructions and/or computer data embodying the invention, may carry such an embodiment of the invention on e.g., a communication network.

Embodiments may be embodied in many different ways as a software component. For example, it may be a stand-alone software package, or it may be a software package incorporated as a "tool" in a larger software product, such as, for example, a scientific modeling product. It may be downloadable from a network, for example, a website, as a stand-alone product or as an add-in package for installation in an existing software application. It may also be available as a client-server software application, or as a web-enabled software application.

While various embodiments of the present invention have been described above, it should be understood that they have been presented by way of example only, and not limitation. Thus, the breadth and scope of the present invention should not be limited by any of the above-described exemplary embodiments, but should instead be defined only in accordance with the following claims and their equivalents.

## Claims

1. A computer-implemented method in a computer modeling environment having generative components, the method comprising:
defining an update method of a parent generative component feature including means for creating a collection containing at least one child generative component feature;
creating a parent generative component feature having the defined update method;
executing the update method for the parent generative component feature including creating the collection of child generative component features; and
returning the collection as the value of the update method, wherein the contents of the collection are automatically associated with the parent generative component feature.

2. The method of claim 1, wherein defining the update method comprises defining the update method with a return value and at least one argument.

3. The method of claim 2, wherein creating the collection of child generative component features includes setting a value for at least one of a setting or a property for a child generative component feature, and wherein the at least one argument comprises at least one of:
a value indicating a number of child generative component features to create in the collection; or
the value for the child generative component feature setting or property.

4. The method of claim 1, further comprising:
performing an action on the parent generative component feature, wherein the action is automatically performed on the child generative component features in the collection of the parent generative component feature.

5. The method of claim 1, wherein executing the update method comprises:
executing the update method as part of a generative component script.

6. The method of claim 1, further comprising:
updating a generative component graph to include the collection; and displaying one of a symbolic representation or a geometric representation of the generative component graph.

7. The method of claim 1, further comprising:
storing the update method and the collection on a computer-readable medium.

8. The method of claim 1, further comprising:
downloading software to a computer system, which when executed by the computer system causes the computer system to perform operations comprising the method of claim 1; or
providing downloadable software to a computer system, which when executed by the computer system causes the computer system to perform operations comprising the method of claim 1.

9. A generative component system in a computer modeling environment comprising:
a parent generative component feature comprising:
at least one user-defined update method having a return value; and
a collection of a plurality of child generative component features created when the at least one user-defined update method is executed;
a generative component graph comprising:
at least two generative component features, including at least one parent generative component feature, and at least one relationship between the at least two generative component features; and
at least one of a memory to store, or a display to display, the generative component features in the generative component graph.

10. The generative component system of claim 9, wherein the generative component graph includes at least one of:
a symbolic representation to display the generative component features in the generative component graph and the relationships among the generative component features in the graph; or
a geometric representation to display information about a generative component feature in the generative component graph.

11. The generative component system of claim 10, wherein the symbolic representation represents the collection of generative component child features as one graph element; and
wherein the geometric representation represents the collection of generative component child features as one graph element for each generative component child feature.

12. The generative component system of claim 9, further comprising at least one of:
a script editor to edit generative component scripts;
a transaction recorder to record transaction on generative component features;
a script execution engine to execute generative component scripts; or
a model including generative component features.

13. A computer program comprising:
one or more computer-executable instructions which, when run on a computer, causes the computer system to define an update method for a parent generative component feature;
one or more computer-executable instructions which, when run on a computer, causes the computer system to create at least one child generative component feature within the update method;
one or more computer-executable instructions which, when run on a computer, causes the computer system to execute the update method including creating at least one child generative component feature and creating a collection containing the at least one child generative component feature; and
one or more computer-executable instructions which, when run on a computer, causes the computer system to return the collection as the value of the update method, wherein the contents of the collection are automatically associated with the parent generative component feature.

14. The computer program of claim 13, wherein the one or more instructions for defining the update method for the parent comprise one or more instructions for defining a sub-function within the update method.

15. The computer program of claim 14, wherein the one or more instructions for defining a sub-function further comprise one or more instructions for receiving an argument indicating a number of times to recursively call the sub-function.

16. A computer-readable medium comprising a computer program according to any of claims 13-15.
